(19)

Europäisches
Patentamt
European
Patent Office
Office européen
des brevets

(11) **EP 4 411 845 A1**

(12) **EUROPEAN PATENT APPLICATION**

(43) Date of publication:
**07.08.2024 Bulletin 2024/32**

(21) Application number: **24154587.0**

(22) Date of filing: **30.01.2024**

(51) International Patent Classification (IPC):
$H01L\ 33/50^{(2010.01)}$    $H01L\ 33/52^{(2010.01)}$
$H01L\ 33/54^{(2010.01)}$    $H01L\ 33/60^{(2010.01)}$

(52) Cooperative Patent Classification (CPC):
**H01L 33/54; H01L 33/505; H01L 33/52;
H01L 33/60**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.01.2023 JP 2023013314
31.08.2023 JP 2023141496**

(71) Applicant: **Nichia Corporation
Anan-shi, Tokushima 774-8601 (JP)**

(72) Inventors:
• **NOAMI, Shunsuke
Anan-shi, Tokushima, 774-8601 (JP)**
• **INOUE, Kakeru
Anan-shi, Tokushima, 774-8601 (JP)**

(74) Representative: **Betten & Resch
Patent- und Rechtsanwälte PartGmbB
Maximiliansplatz 14
80333 München (DE)**

(54) **LIGHT-EMITTING DEVICE**

(57)    The light-emitting device includes a light-emitting element including an element portion, and an electrode disposed on a lower surface of the element portion, a wavelength conversion member disposed on an upper surface and a lateral surface of the element portion, a light-transmissive member disposed on an upper surface of the wavelength conversion member, and a light reflective member disposed on the lower surface of the element portion and a lower surface of the wavelength conversion member. A lateral surface of the wavelength conversion member is exposed from the light-transmissive member, and a thickness of the light-transmissive member is larger than a thickness of the wavelength conversion member.

FIG. 2

EP 4 411 845 A1

**Description**

TECHNICAL FIELD

The present disclosure relates to a light-emitting device.

BACKGROUND

For example, Japanese Patent Publication No. 2016-154204 discloses a light-emitting device having batwing light distribution characteristics.

SUMMARY

An object of the present disclosure is to provide a light-emitting device having wide light distribution characteristics.

According to an aspect of the present disclosure, a light-emitting device includes a light-emitting element including an element portion and an electrode disposed on a lower surface of the element portion; a wavelength conversion member disposed on an upper surface and a lateral surface of the element portion; a light-transmissive member disposed on an upper surface of the wavelength conversion member; and a light reflective member disposed on the lower surface of the element portion and a lower surface of the wavelength conversion member. In the light-emitting device, a lateral surface of the wavelength conversion member is exposed from the light-transmissive member, and a thickness of the light-transmissive member is larger than a thickness of the wavelength conversion member.

According to an aspect of the present disclosure, a light-emitting device includes a light-emitting element including an element portion and an electrode disposed on a lower surface of the element portion; a wavelength conversion member disposed on an upper surface and a lateral surface of the element portion; and a light-transmissive member disposed on an upper surface of the wavelength conversion member and including a light-diffusing material. In the light-emitting device, the light-emitting device includes a device-lateral surface including a lateral surface of the wavelength conversion member and a lateral surface of the light-transmissive member, a thickness of the light-transmissive member is larger than a thickness of the wavelength conversion member, and the light-emitting device has a light distribution characteristic of having a first luminous intensity peak higher than a luminous intensity when a light distribution angle is 0°, in a range of a light distribution angle of 0° to -90°, and a second luminous intensity peak higher than a luminous intensity when the light distribution angle is 0°, in a range of a light distribution angle of 0° to 90°.

The present disclosure can provide a light-emitting device having wide light distribution characteristics.

BRIEF DESCRIPTION OF DRAWINGS

FIG. 1 is a schematic top view of a light-emitting device of an embodiment.
FIG. 2 is a schematic cross-sectional view taken along line II-II in FIG. 1.
FIG. 3 is a schematic bottom view of a light-emitting device of an embodiment.
FIG. 4 is a light distribution characteristic graph of a light-emitting device of an embodiment.
FIG. 5 is a schematic diagram for explaining an objective variable (unevenness value) in multiple regression analysis.
FIG. 6 is a table showing a relationship between a predicted value and a measured value of an unevenness value.
FIG. 7 is a scatter graph showing a relationship between a predicted value and a measured value of an unevenness value.
FIG. 8 is a schematic cross-sectional view for explaining a light-emitting device of another embodiment.
FIG. 9 is a schematic top view of a light-emitting device of an embodiment and a light-emitting device of a comparative example.
FIG. 10 is a Lambertian light distribution characteristic graph.
FIG. 11 is a schematic cross-sectional view of a light-emitting device of a comparative example.
FIG. 12A is a light distribution characteristic graph of a light-emitting device of an embodiment.
FIG. 12B is a light distribution characteristic graph of a light-emitting device of a comparative example.
FIG. 13A is a light distribution chromaticity characteristic graph at an x coordinate of a light-emitting device of an embodiment.
FIG. 13B is a light distribution chromaticity characteristic graph at an x coordinate of a light-emitting device of a comparative example.
FIG. 14A is a light distribution chromaticity characteristic graph at a y coordinate of a light-emitting device of an embodiment.

FIG. 14B is a light distribution chromaticity characteristic graph at ay coordinate of a light-emitting device of a comparative example.

DETAILED DESCRIPTIONS

Light-emitting devices of embodiments are described below with reference to the drawings. Dimensions, materials, shapes, relative arrangements, or the like of constituent members described in the embodiments are not intended to limit the scope of the present disclosure thereto unless otherwise specified, and are merely exemplary. The sizes, positional relationship, or the like of members illustrated in each of the drawings may be exaggerated for clarity of description. Furthermore, in the following description, members having the same names and reference numerals represent the same or similar members, and detailed description of these members is omitted as appropriate. As a cross-sectional view, an end view illustrating only a cut surface may be illustrated.

In the following description, terms indicating specific directions or positions (for example, "upper/upward," "lower/downward," and other terms including or related to those terms) may be used. However, these terms are used merely to make it easy to understand relative directions or positions in the referenced drawing. As long as the relative direction or position is the same as that described in the referenced drawing using the term such as "upper/upward" or "lower/downward," in drawings other than the drawings of the present disclosure, actual products, and the like, members need not be arranged in the same manner as that in the referenced drawing. For example, on the assumption that there are two members, the positional relationship expressed as "upper (or lower)" in the present specification may include a case in which the two members are in contact with each other and a case in which the two members are not in contact with each other and one of the two members is located above (or below) the other member. Furthermore, unless otherwise specified, a case in which a member covers an object to be covered includes a case in which the member is in contact with the object to be covered and directly covers the object to be covered, and a case in which the member is not in contact with the object to be covered and indirectly covers the object to be covered.

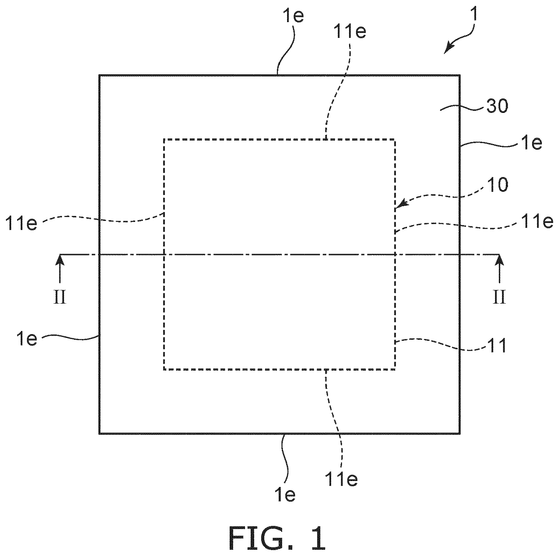

A light-emitting device 1 of an embodiment is described below with reference to FIGS. 1 to 4.

As illustrated in FIG. 1, the light-emitting device 1 has an outer edge 1e having a square shape in top view. The length of one side of the outer edge 1e of the light-emitting device 1 is in a range from 1.0 mm to 2.0 mm, for example.

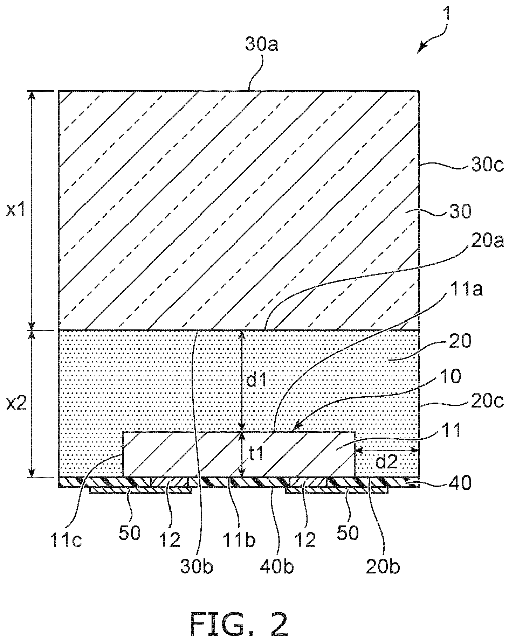

FIG. 2 is a schematic cross-sectional view taken along line II-II in FIG. 1. The light-emitting device 1 includes a light-emitting element 10, a wavelength conversion member 20, a light-transmissive member 30, and a light reflective member 40.

The light-emitting element 10 is, for example, a light-emitting diode (LED). The light-emitting element 10 includes an element portion 11. As illustrated in FIG. 1, the element portion 11 has an outer edge 11e having a square shape in top view. For example, the length of one side of the outer edge 11e of the element portion 11 is in a range from 640 $\mu$m to 1300 $\mu$m. In top view, the outer edge 11e of the element portion 11 extends along the outer edge 1e of the light-emitting device 1. A thickness t1 of the element portion 11 is in a range from 130 $\mu$m to 280 $\mu$m, for example. The thickness t1 of the element portion 11 represents the shortest distance between an upper surface 11a and a lower surface 11b of the element portion 11.

The element portion 11 has a semiconductor structure. The element portion 11 may further include a base of sapphire or the like. The semiconductor structure includes an n-type semiconductor layer, a p-type semiconductor layer, and a light-emitting layer interposed between the n-type semiconductor layer and the p-type semiconductor layer. The light-emitting layer may have a structure such as a double heterojunction or a single quantum well (SQW) structure, or may have a structure with a group of active layers such as a multiple quantum well (MQW) structure. The semiconductor structure emits visible light or ultraviolet light. An example of the semiconductor structure including such a light-emitting layer may include $In_xAl_yGa_{1-x-y}N$ ($0 \le x, 0 \le y, x + y \le 1$).

The semiconductor structure may have a structure including one or more light-emitting layers between the n-type semiconductor layer and the p-type semiconductor layer, or may have a structure in which a structure sequentially including the n-type semiconductor layer, the light-emitting layer, and the p-type semiconductor layer is repeated a plurality of times. When the semiconductor structure includes a plurality of light-emitting layers, the semiconductor structure may include light-emitting layers having different emission peak wavelengths, or may include light-emitting layers having the same emission peak wavelength. Having the same emission peak wavelength includes a case in which there is a variation of about a few nm. A combination of emission peak wavelengths between the plurality of light-emitting layers can be selected as appropriate. For example, when the semiconductor structure includes two light-emitting layers, the light-emitting layers can be selected from light-emitting layers of combinations of blue light and blue light, green light and green light, red light and red light, ultraviolet light and ultraviolet light, blue light and green light, blue light and red light, and green light and red light. Each of the light-emitting layers may include a plurality of active layers having different emission peak wavelengths or may include a plurality of active layers having the same emission peak wavelength.

As illustrated in FIG. 2, the light-emitting element 10 further includes two electrodes 12 disposed on the lower surface 11b of the element portion 11. One of the two electrodes 12 functions as an anode electrode and the other functions as a cathode electrode. The electrode 12 can include, for example, Cu, Ni, Ru, Au, Ag, Pt, Fe, Su, or the like.

The wavelength conversion member 20 is disposed on the upper surface 11a and a lateral surface 11c of the element portion 11, and covers the upper surface 11a and the lateral surface 11c of the element portion 11. Light emitted by the light-emitting layer of the element portion 11 enters the wavelength conversion member 20 from the upper surface 11a and the lateral surface 11c of the element portion 11. The wavelength conversion member 20 includes a first base material and a phosphor. The phosphor converts the wavelength of light emitted by the light-emitting element 10.

Examples of the phosphor that can be used include an yttrium aluminum garnet based phosphor (for example, $Y_3(Al,Ga)_5O_{12}$:Ce), a lutetium aluminum garnet based phosphor (for example, $Lu_3(Al,Ga)_5O_{12}$:Ce), a terbium aluminum garnet based phosphor (for example, $Tb_3(Al,Ga)_5O_{12}$:Ce), a CCA based phosphor (for example, $Ca_{10}(PO_4)_6Cl_2$:Eu), an SAE based phosphor (for example, $Sr_4Al_{14}O_{25}$:Eu), a chlorosilicate based phosphor (for example, $Ca_8MgSi_4O_{16}Cl_2$:Eu), a nitride based phosphor such as a $\beta$-SiAlON based phosphor (for example, $(Si,Al)_3(O,N)_4$:Eu), an $\alpha$-SiAlON based phosphor (for example, $Ca(Si,Al)_{12}(O,N)_{16}$:Eu), an SLA based phosphor (for example, $SrLiAl_3N_4$:Eu), a CASN based phosphor (for example, $CaAlSiN_3$:Eu), or an SCASN based phosphor (for example, $(Sr,Ca)AlSiN_3$:Eu), a fluoride based phosphor such as a KSF based phosphor (for example, $K_2SiF_6$:Mn), a KSAF based phosphor (for example, $K_2(Si,Al)F_6$:Mn), or an MGF based phosphor (for example, $3.5MgO \cdot 0.5MgF_2 \cdot GeO_2$:Mn), a phosphor having a perovskite structure (for example, $CsPb(F,Cl,Br,I)_3$), and a quantum dot phosphor (for example, CdSe, InP, $AgInS_2$, or $AgInSe_2$).

The first base material of the wavelength conversion member 20 is transmissive to light emitted by the light-emitting element 10. The first base material includes, for example, a resin having good heat resistance, weather resistance, and light resistance. Examples of such a resin include a silicone resin, an epoxy resin, a urea resin, a phenol resin, an acrylic resin, a urethane resin, a fluororesin, and a resin including two or more kinds of these resins.

The light-transmissive member 30 is disposed on an upper surface 20a of the wavelength conversion member 20. A lateral surface 20c of the wavelength conversion member 20 is exposed from the light-transmissive member 30. The lateral surface 20c of the wavelength conversion member 20 and a lateral surface 30c of the light-transmissive member 30 are continuous in the same plane.

Light emitted by the light-emitting element 10 and light wavelength-converted by the phosphor are incident on the light-transmissive member 30 from the upper surface 20a of the wavelength conversion member 20. The light-transmissive member 30 diffuses light incident from the upper surface 20a of the wavelength conversion member 20. The light-transmissive member 30 includes a second base material and a first additive that diffuses light. The first additive is a light-diffusing material.

Examples of the first additive (light-diffusing material) that can be used include silicon oxide, titanium oxide, aluminum oxide, and barium titanate. The light-transmissive member 30 may include a filler for adjusting viscosity in addition to any of these light-diffusing materials.

The second base material is transmissive to light emitted by the light-emitting element 10 and light wavelength-converted by the phosphor. The material of the second base material can be the same material as the material of the first base material of the wavelength conversion member 20, for example. By making a refractive index of the first base material and a refractive index of the second base material substantially the same, refraction and reflection at an interface between the wavelength conversion member 20 and the light-transmissive member 30 can be reduced. Thus, the light distribution characteristics of the light-emitting device 1 can be easily adjusted by the concentration of the phosphor and/or the concentration of the first additive included in the light-transmissive member 30, and desired light distribution characteristics can be easily obtained. The fact that the refractive index of the first base material and the refractive index of the second base material are substantially the same means that the difference between the refractive index of the first base material and the refractive index of the second base material is within 0.3.

The refractive index of the first base material of the wavelength conversion member 20 may be higher than the refractive index of the second base material of the light-transmissive member 30. Alternatively, the refractive index of the first base material of the wavelength conversion member 20 may be lower than the refractive index of the second base material of the light-transmissive member 30. When the refractive index of the first base material is higher than the refractive index of the second base material, the luminous intensity of light emitted from the device-lateral surface of the light-emitting device 1 can be increased more easily as compared with when the refractive index of the first base material is lower than the refractive index of the second base material. When the refractive index of the first base material is lower than the refractive index of the second base material, reflection at an interface between the first base material and the second base material can be easily reduced and the luminous intensity of light emitted from the upper surface of the light-emitting device 1 can be easily increased as compared with when the refractive index of the first base material is higher than the refractive index of the second base material.

Light-emitting surfaces of the light-emitting device 1 includes an upper surface 30a of the light-transmissive member 30, the lateral surface 30c of the light-transmissive member 30, and the lateral surface 20c of the wavelength conversion member 20. The device-lateral surfaces of the light-emitting device 1 includes the lateral surface 20c of the wavelength conversion member 20 and the lateral surface 30c of the light-transmissive member 30.

The light reflective member 40 is disposed on the lower surface 11b of the element portion 11 and a lower surface 20b of the wavelength conversion member 20, and covers the lower surface 11b of the element portion 11 and the lower surface 20b of the wavelength conversion member 20. The light reflective member 40 has reflectivity with respect to light emitted by the light-emitting element 10 and light wavelength-converted by the phosphor. The light reflective member 40 allows light directed downward from the light-emitting element 10 and the wavelength conversion member 20 to be reflected toward the light-emitting surface of the light-emitting device 1 above the light reflective member 40 (the upper surface 30a of the light-transmissive member 30, the lateral surface 30c of the light-transmissive member 30, and the lateral surface 20c of the wavelength conversion member 20). Thus, the amount of light from the light-emitting surface of the light-emitting device 1 can be increased. The device-lateral surface of the light-emitting device 1 further includes a lateral surface of the light reflective member 40.

The light reflective member 40 includes a third base material and a second additive. The third base material can use the same material as the material of the first base material. The second additive can use the same material as the material of the first additive.

The light reflective member 40 can cover and protect a lateral surface of the electrode 12. Lower surfaces of the electrodes 12 are exposed from the light reflective member 40.

A thickness of the light reflective member 40 can be smaller than a thickness x2 of the wavelength conversion member 20 and a thicknesses x1 of the light-transmissive member 30. The thickness of the light reflective member 40 is, for example, in a range from 0.015 mm to 0.06 mm.

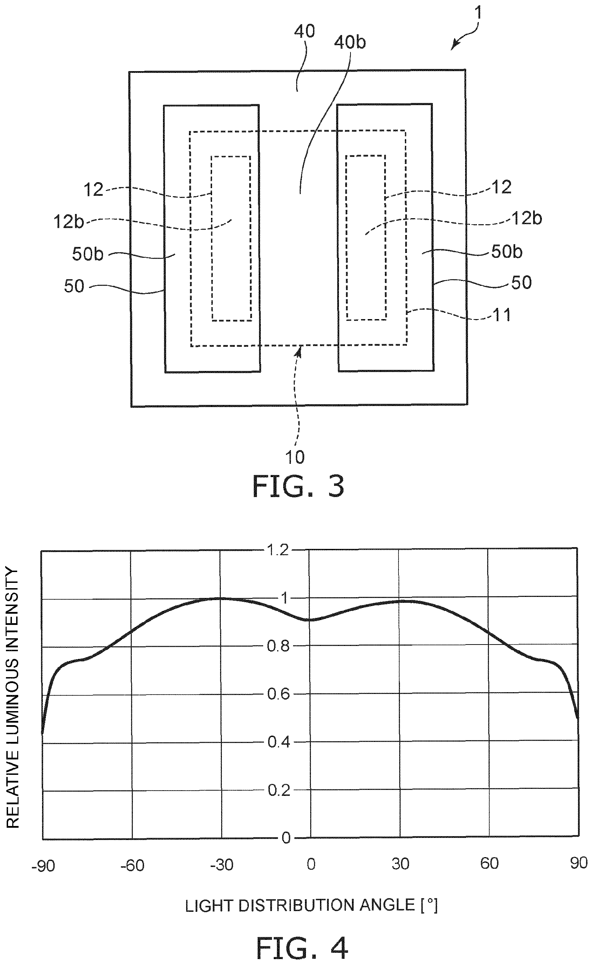

The light-emitting device 1 can further include a metal film 50. The metal film 50 is continuously disposed on the lower surface of the electrode 12 and a lower surface 40b of the light reflective member 40, and is electrically connected to the electrode 12. Two metal films 50 are disposed apart from each other so as to respectively correspond to two electrodes 12 on an anode side and a cathode side. As illustrated in FIG. 3, an area of a lower surface 50b of the metal film 50 is larger than an area of a lower surface 12b of the electrode 12. Thus, a bonding area between the light-emitting device 1 and an external circuit (for example, a wiring substrate) can be increased, and the reliability can be improved. The metal film 50 can include, for example, Cu, Ni, Ru, Au, Ag, Pt, Fe, Su, or the like.

The thickness x1 of the light-transmissive member 30 is larger than the thickness x2 of the wavelength conversion member 20. The thickness x1 of the light-transmissive member 30 represents the shortest distance between the upper surface 30a and a lower surface 30b of the light-transmissive member 30. The thickness x2 of the wavelength conversion member 20 represents the shortest distance between the upper surface 20a and the lower surface 20b of the wavelength conversion member 20. The thickness x1 of the light-transmissive member 30 is, for example, in a range from 0.63 mm to 1.460 mm. The thickness x2 of the wavelength conversion member 20 is, for example, in a range from 0.36 mm to 0.91 mm. The ratio of the thickness x1 of the light-transmissive member 30 to the thickness x2 of the wavelength conversion member 20 (x1/x2) is, for example, in a range from 1.1 to 2.0.

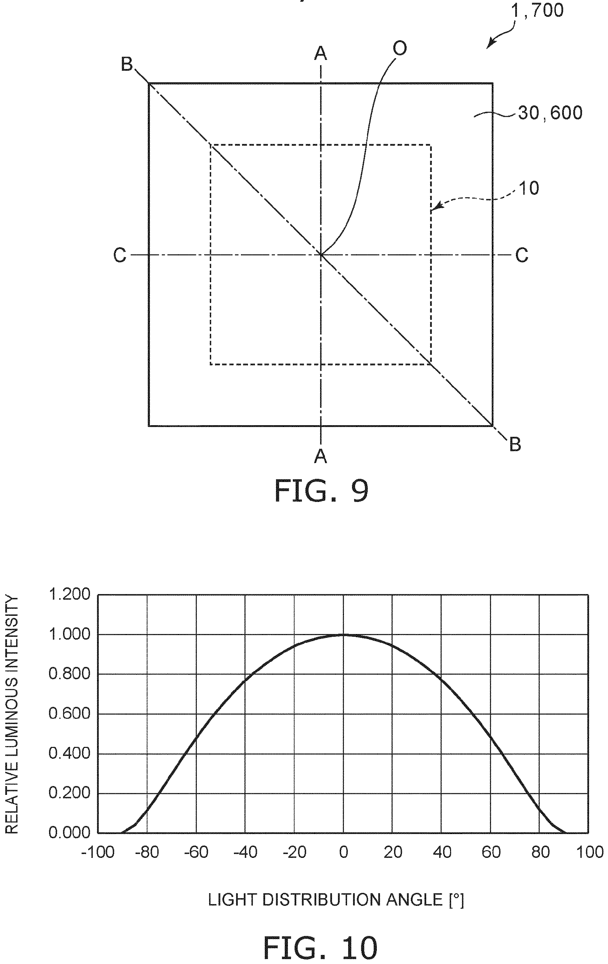

By making the thickness x1 of the light-transmissive member 30 disposed on the upper surface 20a of the wavelength conversion member 20 larger than the thickness x2 of the wavelength conversion member 20, the light distribution characteristics of the light-emitting device 1 can be made wider than the Lambertian light distribution characteristics shown in FIG. 10. In the present specification, the wide light distribution represents a light distribution characteristic of having a luminous intensity peak in a range between a light distribution angle of 0° and $\pm 90°$, the luminous intensity peak being higher than the luminous intensity at the light distribution angle of 0°.

By using the light-emitting device 1 having such light distribution characteristics as, for example, a light source of a lighting fixture, luminance unevenness on a light-emitting surface of the lighting fixture can be reduced even when the distance from the light-emitting device 1 to the light-emitting surface of the lighting fixture is short as a result of a reduction in the thickness of the lighting fixture. Furthermore, a person viewing the light-emitting surface of the lighting fixture can be less likely to feel that the light-emitting device 1 is too bright at certain points. As a result, the thickness of the lighting fixture including the light-emitting device 1 can be reduced and the weight of the lighting fixture can be reduced as the lighting fixture is made thinner.

FIG. 4 is a graph showing an example of light distribution characteristics when one light-emitting device 1 emits light. The light distribution characteristics shown in FIG. 4 are satisfied in a cross section along at least one arbitrary straight line passing through a center O in the top view of the light-emitting device 1 illustrated in FIG. 9, preferably along any straight line. The light-emitting device 1 has light distribution characteristics (so-called batwing light distribution characteristics) of having a first luminous intensity peak higher than the luminous intensity at the light distribution angle of 0°, in a range of a light distribution angle of 0° to -90° (excluding 0° and -90°), and a second luminous intensity peak higher than the luminous intensity at the light distribution angle of 0°, in a range of a light distribution angle of 0° to 90° (excluding 0° and 90°). The light-emitting device 1 preferably has the first luminous intensity peak in a range of a light distribution angle of 20° to 50°, and has the second luminous intensity peak in a range of a light distribution angle of -20° to -50°.

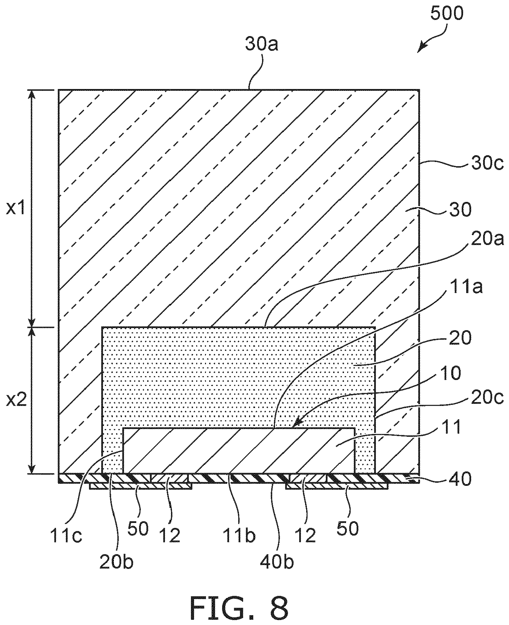

As illustrated in FIG. 8, a light-emitting device 500 including a light-emitting element 10, a wavelength conversion member 20 covering an upper surface and a lateral surface of the light-emitting element 10, and a light-transmissive member 30 covering an upper surface and a lateral surface of the wavelength conversion member 20 is conceivable as another configuration for achieving wide light distribution characteristics of the light-emitting device. In comparison between the light-emitting device 1 of the embodiment and the light-emitting device 500 of another embodiment, the light-emitting device 1 of the embodiment can have an improved luminous flux while achieving wide light distribution characteristics because a lateral surface 20c of the wavelength conversion member 20 is exposed from the light-transmissive member 30. When the light-emitting device 1 of the embodiment and the light-emitting device 500 of the other embodiment have the same outer size, a distance between a lateral surface 11c of an element portion 11 of the light-emitting element 10 and the lateral surface 20c of the wavelength conversion member 20 is short and thus the degree of margin of the positional deviation of the light-emitting element 10 with respect to the wavelength conversion member 20 is reduced in the light-emitting device 500 of the other embodiment in which the light-transmissive member 30 covers the lateral surface of the wavelength conversion member 20 as compared with the light-emitting device 1 of the embodiment. In contrast, in the light-emitting device 1 of the embodiment in which the lateral surface 20c of the wavelength conversion member 20 is exposed from the light-transmissive member 30, a distance d2 between the lateral surface 11c of the element portion 11 and the lateral surface 20c of the wavelength conversion member 20 can be made long and the positional deviation of the light-emitting element 10 with respect to the wavelength conversion member 20 can be reduced as compared with the light-emitting device 500 of the other embodiment. Thus, in the light-emitting device 1 of the embodiment, the deviation of the light distribution chromaticity of the light-emitting device 1 due to the positional deviation of the light-emitting element 10 can be reduced.

The light distribution chromaticity is described below. "Light distribution" and "light distribution characteristics," which are widely used in general, represent a luminous intensity distribution in each direction from a light source and characteristics thereof. On the other hand, the "light distribution chromaticity" and the "light distribution chromaticity characteristics" respectively refer to the chromaticity distribution in each direction from the light source and characteristics thereof. In recent years, light-emitting devices used for lighting applications and planar light sources including a plurality of light-emitting devices are required to have desired light distribution characteristics. However, simply having the desired light distribution characteristics does not consider chromaticity unevenness or chromaticity deviation, and in order to obtain a higher-quality light-emitting device or planar light source in which chromaticity unevenness and chromaticity deviation are reduced, the light distribution chromaticity also needs to be considered.

The total area of four lateral surfaces 30c of the light-transmissive member 30 and four lateral surfaces 20c of the wavelength conversion member 20 can be made larger than the area of the top surface 30a of the light-transmissive member 30. Thus, the amount of light emitted from all lateral surfaces of the light-emitting device 1 can be made larger than the amount of light emitted from the upper surface thereof, so that the light distribution characteristics of the light-emitting device 1 can be easily made to be a wide light distribution.

Preferably,

$$y = 1.02 + (-0.0000270 \times x1) + (-1.73 \times 10^{-5} \times x2)...(1)$$

satisfies a range from 0.99 to 1.01. y is an objective variable in a multiple regression equation in which the thickness x1 of the light-transmissive member 30 and the thickness x2 of the wavelength conversion member 20 are explanatory variables, and represents an unevenness value.

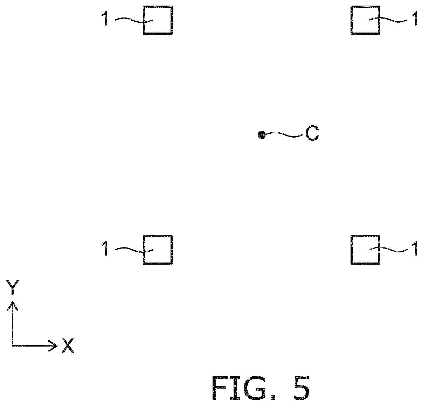

The unevenness value represents the ratio of the luminance of the region between the light-emitting devices to the luminance of the region immediately above the light-emitting device 1. FIG. 5 is a schematic top view of a part of a planar light source in which a plurality of light-emitting devices 1 are disposed on a substrate in a square lattice point pattern. As illustrated in FIG. 5, the luminance of the region between the light-emitting devices represents the luminance at a center C of a region between four light-emitting devices 1 disposed at equal intervals in a first direction X and a second direction Y orthogonal to each other. When the luminance of the region immediately above the light-emitting device 1 is the same as the luminance of the region between the light-emitting devices, the unevenness value is 1. As the unevenness value is closer to 1, the difference between the luminance of the region immediately above the light-emitting device 1 and the luminance of the region between the light-emitting devices is smaller. The unevenness value correlates with the light distribution characteristics of the light-emitting device 1. When the light distribution characteristics of the light-emitting device 1 become wider, the difference between the luminance of the region immediately above the light-emitting device 1 and the luminance of the region between the light-emitting devices tends to become smaller.

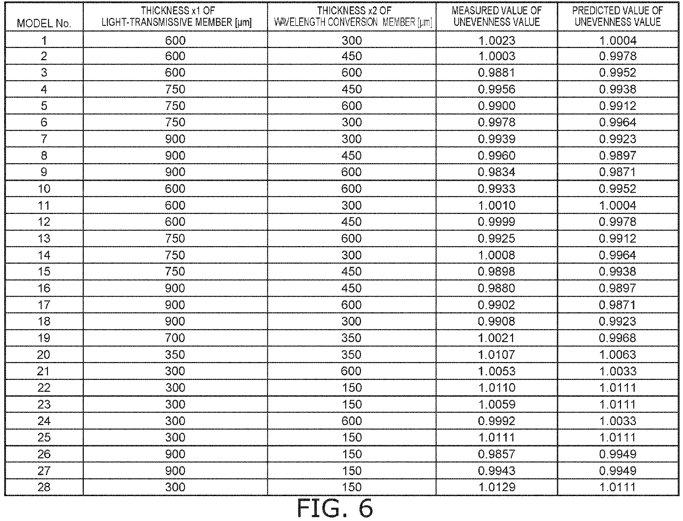

Equation (1) above was obtained by multiple regression analysis from the explanatory variables x1 and x2 of 28 models and the measured values of the unevenness value shown in FIG. 6. The coefficients in equation (1) above are partial regression coefficients. In the multiple regression analysis, the degree of influence on the unevenness value was verified using explanatory variables other than x1 and x2, which are considered to have an influence on the unevenness value. A factor having a low p-value representing a significant probability of a coefficient of an explanatory variable was extracted by a stepwise method. As a result, the thickness x1 of the light-transmissive member 30 and the thickness x2 of the wavelength conversion member 20 were calculated in descending order of the p-value. That is, it was concluded that the thickness x1 of the light-transmissive member 30 and the thickness x2 of the wavelength conversion member 20 can be used as explanatory variables having a high correlation with the unevenness value.

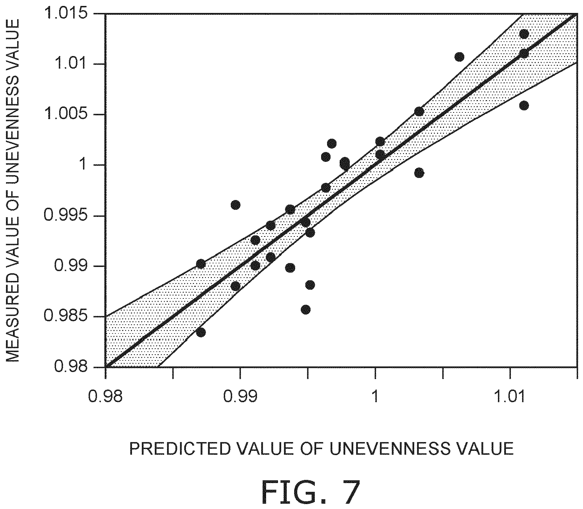

FIG. 7 is a scatter graph in which the predicted values and the measured values of the unevenness value shown in FIG. 6 are plotted. The horizontal axis represents the predicted values of the unevenness value, and the vertical axis represents the measured values of the unevenness value. The measured values of the unevenness value are values obtained by simulation. The predicted values of the unevenness value are values obtained by Equation (1) above. In this scatter graph, a thick solid line indicates a straight line on which the predicted values and the measured values of the unevenness value coincide with each other.

The result of FIG. 7 indicates that the unevenness value can be predicted with sufficient accuracy with respect to the measured values from Equation (1) above. Consequently, by adjusting the thickness x1 of the light-transmissive member 30 and the thickness x2 of the wavelength conversion member 20 such that Equation (1) above satisfies a range from 0.99 to 1.01, the light distribution characteristics of the light-emitting device 1 can be widened, so that the difference between the luminance of the region immediately above the light-emitting device 1 and the luminance of the region between the light-emitting devices can be easily reduced.

A distance d1 between the upper surface 11a of the element portion 11 and the upper surface 20a of the wavelength conversion member 20 can be made longer than the distance d2 between the lateral surface 11c of the element portion 11 and the lateral surface 20c of the wavelength conversion member 20. The distance d1 represents the shortest distance between the upper surface 11a of the element portion 11 and the upper surface 20a of the wavelength conversion member 20. The distance d2 represents the shortest distance between the lateral surface 11c of the element portion 11 and the lateral surface 20c of the wavelength conversion member 20. The distance d1 is, for example, in a range from 220 $\mu$m to 640 $\mu$m. The thickness d2 is, for example, in a range from 170 $\mu$m to 360 $\mu$m. Light emitted from the element portion 11 includes immediately upper light components emitted from the upper surface 11a and lateral surface light components emitted from the lateral surface 11c. Because the amount of the immediately upper light components is larger than the amount of the lateral surface light components, the distance d1 is set to larger than the distance d2, so that variations in chromatic light distribution characteristics between a region immediately above the light-emitting device 1 and a region lateral to the light-emitting device 1 can be easily reduced.

The ratio of the total thickness of the light-emitting device 1 to one side of the outer edge 1e thereof can be set in a range from 1.01 to 1.24. The total thickness of the light-emitting device 1 is the sum of the thickness x1 of the light-transmissive member 30, the thickness x2 of the wavelength conversion member 20, and the thickness of the light reflective member 40. When the light-emitting device 1 includes the metal film 50, the total thickness of the light-emitting device 1 is the sum of the thickness x1 of the light-transmissive member 30, the thickness x2 of the wavelength conversion member 20, the thickness of the light reflective member 40, and the thickness of the metal film 50.

The above distance d1 may be larger than the thickness t1 of the element portion 11. The distance d1 may also be equal to or smaller than the thickness t1 of the element portion 11. Also in this case, d1 is set to larger than d2, so that variations in chromatic light distribution characteristics between the region immediately above the light-emitting device 1 and the region lateral to the light-emitting device 1 can be easily reduced.

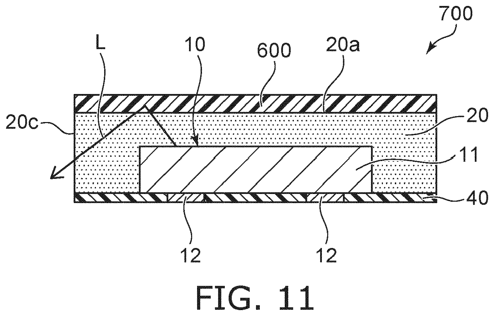

An example of a light-emitting device that can achieve a light distribution wider than the Lambertian light distribution characteristics is a light-emitting device 700 of a comparative example illustrated in FIG. 11. The light-emitting device 700 of the comparative example includes the same members (the light-emitting element 10, the wavelength conversion member 20, and the light reflective member 40) as the light-emitting device 1 of the embodiment, and a light adjustment member 600 disposed on the upper surface 20a of the wavelength conversion member 20. The light adjustment member 600 includes a light-transmissive resin and a light-diffusing material, and substantially blocks upward light from the element portion 11. The thickness of the light adjustment member 600 is smaller than the thickness of the wavelength conversion member 20 (the shortest distance between the upper surface of the light reflective member 40 and the upper surface of the wavelength conversion member 20).

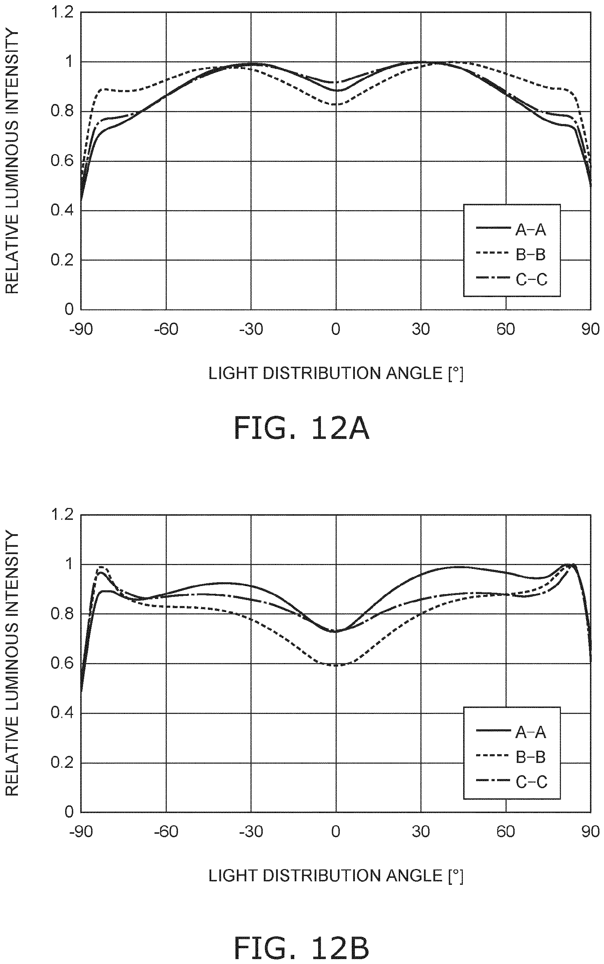

Results of measuring light distribution characteristics and light distribution chromaticity characteristics for each of the light-emitting device 1 of the embodiment and the light-emitting device 700 of the comparative example are described below with reference to FIGS. 12A to 14B. In FIGS. 12A to 14B, each solid line indicates the light distribution characteristics or the light distribution chromaticity characteristics in a cross section taken along line A-A illustrated in FIG. 9, each broken line indicates the light distribution characteristics or the light distribution chromaticity characteristics in a cross section taken along line B-B illustrated in FIG. 9, and each one dot chain line indicates the light distribution characteristics or the light distribution chromaticity characteristics in a cross section taken along line C-C illustrated in FIG. 9.

FIG. 12A shows the light distribution characteristics of the light-emitting device 1 of the embodiment. FIG. 12B shows the light distribution characteristics of the light-emitting device 700 of the comparative example. In order to obtain a batwing light distribution in the light-emitting device 700, the concentration and the like of the light-diffusing material included in the light adjustment member 600 are adjusted to substantially block upwardly traveling light from the element portion 11. The concentration of the light-diffusing material included in the light adjustment member 600 in the light-emitting device 700 of the comparative example is significantly higher than the concentration of the light-diffusing material included in the light-transmissive member 30 in the light-emitting device 1 of the embodiment. In the light-emitting device 700 of the comparative example configured as described above, the amount of light L that is emitted by the light-emitting element 10 and reflected by the light adjustment member 600 to return into the wavelength conversion member 20, which is return light, is increased. The return light L can pass through the wavelength conversion member 20 again and be extracted from the lateral surface 20c of the wavelength conversion member 20 to the outside of the light-emitting device 700. When the distance that the return light L travels in the wavelength conversion member 20 is increased, the amount of light subjected to wavelength conversion out of the light emitted by the light-emitting element 10 is increased, and chromaticity unevenness may occur.

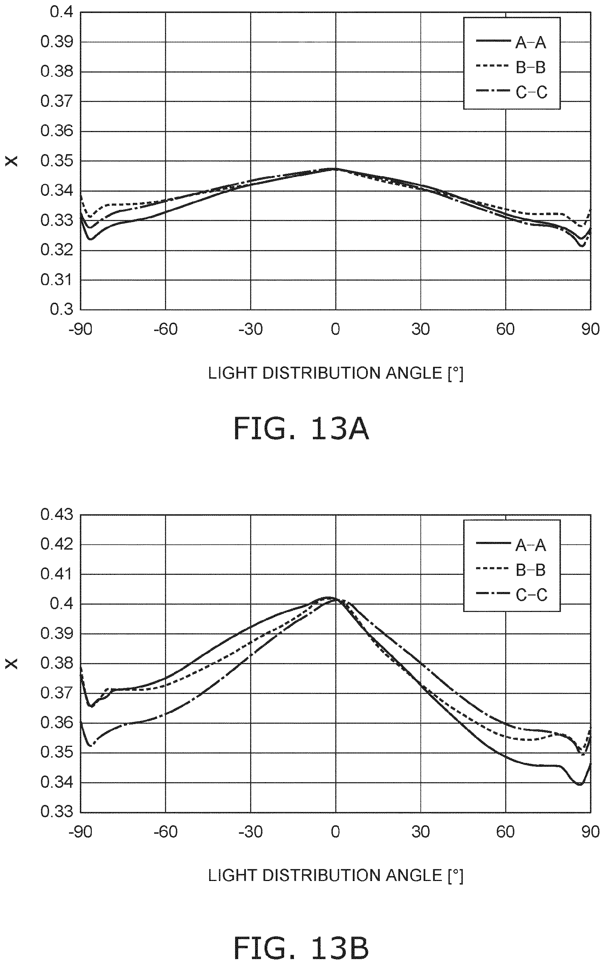

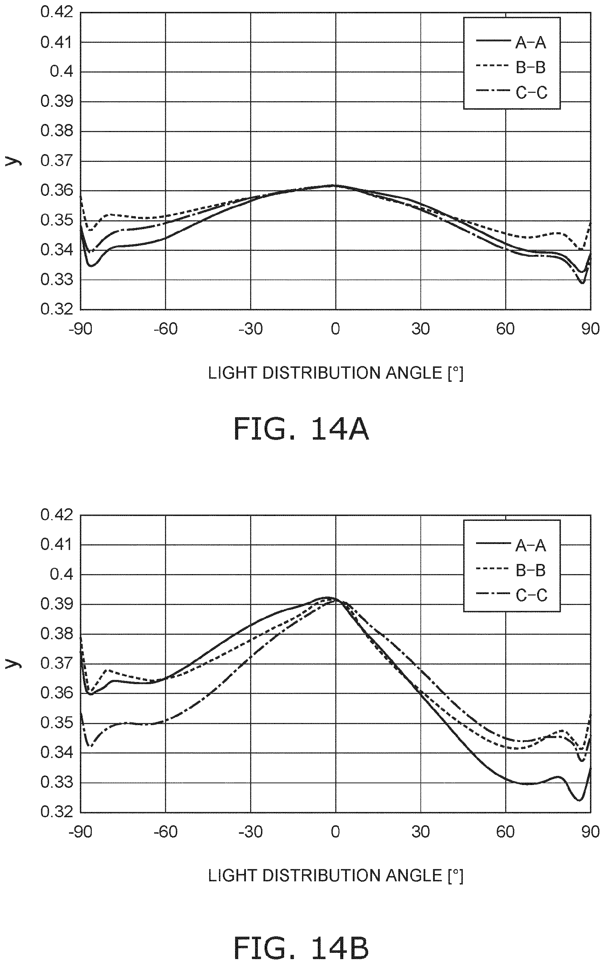

FIGS. 13A and 14A show the light distribution chromaticity characteristics of the light-emitting device 1 of the embodiment. FIGS. 13B and 14B show the light distribution chromaticity characteristics of the light-emitting device 700 of the comparative example. FIGS. 13A and 13B show light distribution chromaticity characteristics at an x coordinate in CIE chromaticity. FIGS. 14A and 14B show light distribution chromaticity characteristics at a y coordinate in CIE chromaticity. In the light distribution chromaticity characteristics (FIGS. 13B and 14B) of the light-emitting device 700 of the comparative example, the rate of change in chromaticity with respect to a difference in light distribution angle is larger and the color unevenness is larger than in the light distribution chromaticity characteristics (FIGS. 13A and 14A) of the light-emitting device 1 of the embodiment.

That is, in the light-emitting device 700 of the comparative example, even though the light distribution characteristics (FIG. 12B) are set to the batwing light distribution characteristics, the chromaticity unevenness is larger than the chromaticity unevenness in the light-emitting device 1 of the embodiment due to the influence of the return light L described above.

In the light-emitting device 1 of the embodiment, both luminance unevenness and chromaticity unevenness can be reduced.

Examples of the material of the second base material of the light-transmissive member 30 include a silicone resin such as a phenyl silicone resin. In this case, the light-diffusing material included in the light-transmissive member 30 is preferably a light-diffusing material, such as silicon oxide, having a small refractive index difference from a phenyl silicone resin. For example, when titanium oxide is used as the light-diffusing material, the return light increases because the refractive index is large. To avoid this, the refractive index difference is preferably maintained at a certain level or lower. Examples of the light-diffusing material include silicon oxide and aluminum oxide. Of silicon oxide and aluminum oxide, silicon oxide, which has a smaller refractive index difference from the phenyl silicone resin, is preferable. By reducing the refractive index difference between the second base material and the light-diffusing material in the light-transmissive member 30, return light that is reflected at an interface between the second base material and the light-diffusing material and returns into the wavelength conversion member 20 can be reduced.

The concentration of the light-diffusing material in the light-transmissive member 30 is preferably in a range from 13 wt% to 40 wt%. Thus, a value close to 1 is obtained as the unevenness value described above, and the difference between the luminance of the region immediately above the light-emitting device 1 and the luminance of the region between the light-emitting devices is likely to be small.

The embodiment of the present disclosure may include the aspects below.

Embodiments of the present invention have been described above with reference to specific examples. However, the present invention is not limited to these specific examples. All aspects that can be practiced by a person skilled in the art changing the design as appropriate based on the above-described embodiments of the present invention are also included in the scope of the present invention, as long as they encompass the spirit of the present invention. In addition, in the spirit of the present invention, a person skilled in the art can conceive of various modified examples and alterations, and those modified examples and alterations will also fall within the scope of the present invention.

**Claims**

1. A light-emitting device comprising:

   a light-emitting element comprising an element portion, and an electrode disposed on a lower surface of the element portion;
   a wavelength conversion member disposed on an upper surface and a lateral surface of the element portion;
   a light-transmissive member disposed on an upper surface of the wavelength conversion member; and
   a light reflective member disposed on the lower surface of the element portion and a lower surface of the wavelength conversion member, wherein:

a lateral surface of the wavelength conversion member is exposed from the light-transmissive member, and a thickness of the light-transmissive member is larger than a thickness of the wavelength conversion member.

2. The light-emitting device according to claim 1, wherein a distance between the upper surface of the element portion and the upper surface of the wavelength conversion member is greater than a distance between the lateral surface of the element portion and the lateral surface of the wavelength conversion member.

3. The light-emitting device according to claim 1 or 2, wherein, when a thickness of the light-transmissive member is x1 and a thickness of the wavelength conversion member is x2, $y = 1.02 + (-0.0000270 \times x1) + (-1.73 \times 10^{-5} \times x2)$ satisfies a range from 0.99 to 1.01.

4. The light-emitting device according to any of claims 1 to 3, wherein:

the light-emitting device has an outer edge having a square shape in top view, and
a ratio of a total thickness of the light-emitting device to one side of the outer edge having the square shape of the light-emitting device is in a range from 1 to 2.

5. The light-emitting device according to any of claim 1 to 4, wherein the light-emitting device has a light distribution characteristic of having a first luminous intensity peak higher than a luminous intensity at a light distribution angle of 0°, in a range of a light distribution angle of 0° to -90°, and a second luminous intensity peak higher than a luminous intensity at the light distribution angle of 0°, in a range of a light distribution angle of 0° to 90°.

6. A light-emitting device comprising:

a light-emitting element comprising an element portion, and an electrode disposed on a lower surface of the element portion;
a wavelength conversion member disposed on an upper surface and a lateral surface of the element portion; and
a light-transmissive member disposed on an upper surface of the wavelength conversion member and including a light-diffusing material, wherein:

the light-emitting device has a device-lateral surface including a lateral surface of the wavelength conversion member and a lateral surface of the light-transmissive member,
a thickness of the light-transmissive member is greater than a thickness of the wavelength conversion member, and
the light-emitting device has a light distribution characteristic of having a first luminous intensity peak higher than a luminous intensity at a light distribution angle of 0°, in a range of a light distribution angle of 0° to -90°, and a second luminous intensity peak higher than a luminous intensity at the light distribution angle of 0°, in a range of a light distribution angle of 0° to 90°.

7. The light-emitting device according to claim 6, wherein a concentration of the light-diffusing material in the light-transmissive member is in a range from 13 wt% to 40 wt%.

FIG. 1

FIG. 2

FIG. 3

LIGHT DISTRIBUTION ANGLE [°]

FIG. 4

FIG. 5

| MODEL No. | THICKNESS x1 OF LIGHT-TRANSMISSIVE MEMBER [µm] | THICKNESS x2 OF WAVELENGTH CONVERSION MEMBER [µm] | MEASURED VALUE OF UNEVENNESS VALUE | PREDICTED VALUE OF UNEVENNESS VALUE |
|---|---|---|---|---|
| 1 | 600 | 300 | 1.0023 | 1.0004 |
| 2 | 600 | 450 | 1.0003 | 0.9978 |
| 3 | 600 | 600 | 0.9881 | 0.9952 |
| 4 | 750 | 450 | 0.9956 | 0.9938 |
| 5 | 750 | 600 | 0.9900 | 0.9912 |
| 6 | 750 | 300 | 0.9978 | 0.9964 |
| 7 | 900 | 300 | 0.9939 | 0.9923 |
| 8 | 900 | 450 | 0.9960 | 0.9897 |
| 9 | 900 | 600 | 0.9834 | 0.9871 |
| 10 | 600 | 600 | 0.9933 | 0.9952 |
| 11 | 600 | 300 | 1.0010 | 1.0004 |
| 12 | 600 | 450 | 0.9999 | 0.9978 |
| 13 | 750 | 600 | 0.9925 | 0.9912 |
| 14 | 750 | 300 | 1.0008 | 0.9964 |
| 15 | 750 | 450 | 0.9898 | 0.9938 |
| 16 | 900 | 450 | 0.9880 | 0.9897 |
| 17 | 900 | 600 | 0.9902 | 0.9871 |
| 18 | 900 | 300 | 0.9908 | 0.9923 |
| 19 | 700 | 350 | 1.0021 | 0.9968 |
| 20 | 350 | 350 | 1.0107 | 1.0063 |
| 21 | 300 | 600 | 1.0053 | 1.0033 |
| 22 | 300 | 150 | 1.0110 | 1.0111 |
| 23 | 300 | 150 | 1.0059 | 1.0111 |
| 24 | 300 | 600 | 0.9992 | 1.0033 |
| 25 | 300 | 150 | 1.0111 | 1.0111 |
| 26 | 900 | 150 | 0.9857 | 0.9949 |
| 27 | 900 | 150 | 0.9943 | 0.9949 |
| 28 | 300 | 150 | 1.0129 | 1.0111 |

FIG. 6

FIG. 7

FIG. 8

FIG. 9

LIGHT DISTRIBUTION ANGLE [°]

FIG. 10

FIG. 11

FIG. 12A

FIG. 12B

FIG. 13A

FIG. 13B

FIG. 14A

FIG. 14B

Europäisches
Patentamt

European
Patent Office

Office européen
des brevets

# EUROPEAN SEARCH REPORT

Application Number

EP 24 15 4587

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/330998 A1 (PARK II WOO [KR] ET AL) 16 November 2017 (2017-11-16) * paragraphs [0019], [0049], [0062], [0097], [0109] - [0111]; figures 1,14 * | 1-7 | INV. H01L33/50 H01L33/52 H01L33/54 H01L33/60 |
| X | US 2015/129919 A1 (LIU CHIEN-LIANG [TW] ET AL) 14 May 2015 (2015-05-14) * paragraphs [0054], [0056]; figure 9h * | 1 | |
| X | US 2019/165225 A1 (KÜHNELT MICHAEL [DE] ET AL) 30 May 2019 (2019-05-30) * paragraphs [0072] - [0078]; figures 2,3 * | 1 | |
| X | US 2015/194580 A1 (LOWES THEODORE [US] ET AL) 9 July 2015 (2015-07-09) * paragraphs [0106] - [0110]; figures 17,18 * | 1 | |

|  |
|---|
| TECHNICAL FIELDS SEARCHED (IPC) |
| H01L |

The present search report has been drawn up for all claims

| Place of search | Date of completion of the search | Examiner |
|---|---|---|
| The Hague | 6 June 2024 | Chin, Patrick |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EP 4 411 845 A1

## ANNEX TO THE EUROPEAN SEARCH REPORT
## ON EUROPEAN PATENT APPLICATION NO.

EP 24 15 4587

06-06-2024

| Patent document cited in search report | Publication date | Patent family member(s) | Publication date |
|---|---|---|---|
| US 2017330998 A1 | 16-11-2017 | CN 105762237 A | 13-07-2016 |
| | | KR 20160084562 A | 14-07-2016 |
| | | US 2016197229 A1 | 07-07-2016 |
| | | US 2017330998 A1 | 16-11-2017 |
| US 2015129919 A1 | 14-05-2015 | CN 104633493 A | 20-05-2015 |
| | | CN 108533993 A | 14-09-2018 |
| | | DE 102014016854 A1 | 21-05-2015 |
| | | JP 6999615 B2 | 18-01-2022 |
| | | JP 7277557 B2 | 19-05-2023 |
| | | JP 2015095658 A | 18-05-2015 |
| | | JP 2019195103 A | 07-11-2019 |
| | | JP 2022028040 A | 14-02-2022 |
| | | KR 20150056055 A | 22-05-2015 |
| | | KR 20200068610 A | 15-06-2020 |
| | | KR 20210057718 A | 21-05-2021 |
| | | TW 201523928 A | 16-06-2015 |
| | | US 2015129919 A1 | 14-05-2015 |
| US 2019165225 A1 | 30-05-2019 | CN 109075237 A | 21-12-2018 |
| | | DE 102016106833 A1 | 19-10-2017 |
| | | KR 20180125578 A | 23-11-2018 |
| | | US 2019165225 A1 | 30-05-2019 |
| | | WO 2017178332 A1 | 19-10-2017 |
| US 2015194580 A1 | 09-07-2015 | CN 104364919 A | 18-02-2015 |
| | | CN 108172678 A | 15-06-2018 |
| | | EP 2859596 A2 | 15-04-2015 |
| | | EP 3758078 A1 | 30-12-2020 |
| | | TW 201405884 A | 01-02-2014 |
| | | US 2013328073 A1 | 12-12-2013 |
| | | US 2013329425 A1 | 12-12-2013 |
| | | US 2015194580 A1 | 09-07-2015 |
| | | WO 2013188189 A2 | 19-12-2013 |

EPO FORM P0459

For more details about this annex : see Official Journal of the European Patent Office, No. 12/82

**REFERENCES CITED IN THE DESCRIPTION**

**Patent documents cited in the description**

- JP 2016154204 A